# EUROPEAN PATENT APPLICATION

(11) **EP 1 961 755 A1**
(43) Date of publication of application: **27.08.2008**
(21) Application number: 07300805.4
(22) Date of filing: 21.02.2007
(51) Int. Cl.: C07F 3/00, C23C 16/40

(54) **Strontium silylamides, adducts thereof with Lewis bases, preparation thereof and deposition of strontium thin films**

(71) Applicant: L'AIR LIQUIDE, Société Anonyme pour l'Etude et l'Exploitation des Procédés Georges Claude, 75007 Paris (FR)
(72) Inventor: BLASCO, Nicolas, 75321, PARIS CEDEX 07 (FR); PINCHART, Audrey, 75321, PARIS Cedex 07 (FR); DUSSARRAT, Christian, 75321, PARIS CEDEX 07 (FR); DANIELE, Stéphane, 75016, PARIS (FR); DUBOURDIEU, Catherine, 75016, PARIS (FR); CORNIER, Thibaut, 75016, PARIS (FR); HUBERT-PFALZGRAF, Liliane, 75016, PARIS (FR)
(74) Representative: Conan, Philippe Claude

(57) **Abstract**

Compound of the formula (I): 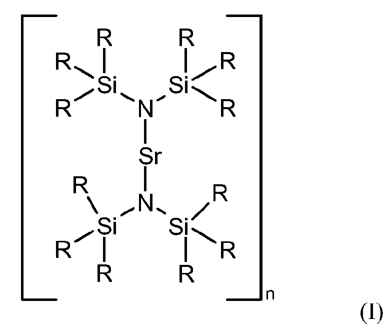 wherein R represents a radical chosen from methyl or ethyl, and n is an integer equal to 1, 2 or 3. Its use in semiconductor manufacturing, as a thin film precursor and a method of its deposition on a substrate.

## Description

The invention relates to new metal-organic, which may be used in the semiconductors industry.

High permittivity oxides are required for future generation semiconductor devices, such as Complementary Metal Oxide Semiconductor (CMOS), Metal Insulator Metal capacitors (MIM) and Dynamic Random Access Memory (DRAM) devices. With the shrink of the critical dimension of CMOS semiconductor devices, the direct tunneling effect affects the achievable leakage current for the conventional SiO₂-based gate oxides. There is thus a need for new materials having a greater dielectric constant.

Strontium-based oxides, such as SrTiO₃ (STO) or Ba₁₋ₓSrₓTiO₃, are highly desired due to their outstanding permittivity values. A k-value of 120 was for example reported for STO, which is a much higher value than the currently considered hafnium-based oxides, the usual k-value of HfO₂ films being rather in the 13 to 25 range, depending on the considered crystalline phase. Such high-k materials are also particularly attractive for deep trench capacitors structures.

Strontium-based compounds thus raise a considerable interest and various deposition processes have been considered, to enable the deposition of strontium oxide - containing thin films, among which are the Chemical Vapor Deposition (CVD) processes.

In fact, there is a crucial need for strontium metal-organic compounds for use as precursors in CVD processes. Today, the available metal-organic strontium compounds lack of optimized properties to enable the proper distribution of sufficient amount of strontium to the CVD chamber. Further, there is a lack of low temperature processes precursors.

At the industrial level, thin films are usually deposited by a vapor phase deposition process. Examples of such processes are the Metal-Organic Chemical Vapor Deposition (MOCVD) process, wherein the metal-organic precursor and the reactant species are introduced altogether in the reaction chamber, or the Atomic Layer Deposition (ALD) process, wherein the metal-organic precursor and the reactant species are sequentially introduced in the reaction chamber. In both processes, the metal-organic precursors are distributed in vapour phase, to the reaction chamber. They can be vaporized, either by liquid injection techniques, or by passing a carrier gas in a heated bubbler containing the metal-organic precursor. The requirements for the metal-organic compounds, which are intended to be used as raw materials in vapour phase deposition processes, thus include the following characteristics:

These compounds must be as volatile as possible, for instance by having a vapour pressure higher than 0.1 Torr (1 Torr = 133.32 Pa) at 100°C;

These compounds must have a melting point as low as possible, for instance below 100°C;

These compounds must be thermally stable enough, to enable a distribution in vapour phase at sufficient vapour pressure, without being decomposed that would entail particles generation;

These compounds must have a similar volatility as the other precursors, which are used during the same process;

These compounds must have a similar reactivity as the other precursors, which are used during the same process, for instance during a SrTiO₃ deposition; and

These compounds must be reactive enough, to enable low temperature deposition processes for certain applications with a limited thermal budget.

Various metal-organic complexes have been considered as a source reagent for Strontium - containing thin film deposition using vapour phases processes. The mostly considered and studied strontium precursors are strontium beta-diketonates, such as
Bis(acetylacetonate) strontium [Sr(acac)₂],
Bis(2,2,6,6-tetramethyl-heptane-3,5-dionate) strontium [Sr(tmhd)₂], and
Bis(hexafluoroacetylacetonate) strontium [Sr(hfac)₂].

However, strontium beta-diketonates are generally solid at room temperature, they often have a very low volatility and they often are oligomers, they generally have a high thermal stability (400°C), which prevents their use in low temperature processes, they generally have a poor reactivity toward moisture, which makes them unsuitable for low temperature H₂O ALD processes, and their use in ALD processes using O₃ as an oxygen source, results in a high carbon containing strontium carbonate, SrCO₃.

More particularly, Sr(tmhd)₂ is a white solid trimer at room temperature. Its melting point is reported at 210°C and its vapour pressure of 0.05 Torr at 230°C. Sr(tmhd)₂ has been investigated by various teams, both in MOCVD and in ALD processes. For instance, Gao et al. evaluated Sr(tmhd)₂ as an ALD precursor at high temperature: 600°C to 725°C (Gao et al. J. Appl. Phys., vol 87, N°1, Jan 2000). Such a high deposition temperature requires a specific design of the other precursors, which would, if possible, be also used at that high temperature, such as titanium precursors for SrTiO₃ depositions. That is why Sr(tmhd)₂ is consequently not an ideal strontium precursor and would not allow optimized future generation processes, either in terms of films properties, of integration into the fabrication line, or of process yield and throughput.

Bis(acetylacetonate) strontium [Sr(acac)₂], presents the same drawbacks as Sr(tmhd)₂ does and bis(hexafluoroacetylacetonate) strontium, [Sr(hfac)₂] in addition, contains fluorine atoms that may affect the film quality by unexpected etching during the deposition process or by incorporation of fluorine atoms in the films and might thus lead to surface and interface roughness.

To overcome some of the drawbacks of conventional strontium beta-diketonates, Lee et al. proposed to use bis(methoxyethoxy-2,2,6,6-tetramethylheptane-3,5-dionate) Strontium [Sr(methd)₂,] (Lee et al., J. Mater. Res. Vol. 14 n°10, Oct. 1999).

Sr(methd)₂ is a liquid at room temperature and a thermal gravimetric analysis of this compound shows a good thermal stability with full evaporation without residue at 398°C. Lee et al. evaluated the behaviour of Sr(methd)₂ in Ba₁₋ₓSrₓTiO₃ (BST) MOCVD from 350°C to 600°C, with Ba(methd)₂ and Ti(mpd)₂(thd)₂ as Ba and Ti precursors respectively. However, Sr(methd)₂ is very viscous at room temperature (105 cp), which makes its handling as a liquid unlikely. Moreover, its poor volatility makes its use non convenient in ALD processes with good step coverage in deep trenches with high aspect ratio. Sr(methd)₂ is also reported U.S. patent 6,689,427, wherein it is used along to with new Ti precursors, to deposit Ba₁₋ₓSrₓTiO₃ films. Sr(methd)₂ is dissolved in n-butyl acetate and distributed by liquid injection. The vaporizer temperature and the precursor solution delivery tube are kept at temperatures as high as 280°C.

Using Sr(methd)₂ as a strontium precursor, Kil et al. overcame the usual carbon incorporation in the O₃ ALD process with strontium β-diketonates, by using remote plasma activated oxygen radicals as oxidant source, and obtained an atomic layer deposition of SrO in the 150-275°C temperature range at 0.78Å/cycle (Kil et al., Chem. Vap. Dep., 2002, 8, n°5). The results are however not satisfactory enough for the man skill in the art, who would rather prefer to get a precursor with a higher reactivity to H₂O.

U.S. patent 5,248,787 discloses that the addition of a neutral oxygen or of a nitrogen donor complexing ligand in the structure of compounds of the diketonate family, such as cyclic or acyclic ethers, to the metal compound (strontium, barium, calcium), enhance the thermal stability of the final complex. An example of such a compound is given: {Sr [CF₃C(O)CHC(O)CF₃]₂2[CH₃OCH₂CH₂OCH₃]}. It is obtained in good yield (94%) and has an acceptable melting point (80-82°C). However, its vapour pressure is in the range of 0.06 Torr at 115°C, which is too low for a vapour phase distribution and its use in MOCVD or ALD processes.

Another disclosed strontium precursor family consists in the alkylcyclopentadienyl strontium compounds.

Ihanus et al. first reported bis[tris(isopropyl)cyclopentadienyl] strontium and bis[pentamethylcyclopentadienyl] strontium, both with tetrahydrofuran adducts as precursors for strontium sulphur ALD (Ihanus et al., Chem. Mater. 2002, 14, 1937-1944).

Vehkamäki et al. then evaluated bis[tris(isopropyl)cyclopentadienyl] Strontium [Sr(iPr₃Cp)₂], without adduct, for SrTiO₃ ALD using Titanium tetrakis(isopropoxide), [Ti(OiPr)₄], as a Ti precursor and H₂O as an oxygen source. SrO and SrTiO₃ ALD films were obtained At 250°C, with deposition rates of respectively 1.1Å/cycle and about 0.5Å/cycle. However there was some evidence of precursor decomposition, preventing self-limited deposition, even at low temperature such as 250°C. This parasitic CVD effect was even more significant at 300°C and 350°C (M. Vehkamäki et al. Chem. Vap. Deposition 2001, 7 N° 2 pages 75-80). Sr(iPr₃Cp)₂ is consequently not an optimized precursor for SrTiO₃ and Ba₁₋ₓSrₓTiO₃ ALD because of its too low thermal stability. In particular, one could not expect a conformal deposition in high aspect ratio trenches.

There is consequently a lack of strontium metal-organic compound having both high volatility and sufficiently low melting point for proper utilization as reagent source for deposition of thin films containing strontium.

That is why the present invention proposes to solve this problem by providing a new strontium metal-organic precursor for the deposition of strontium containing thin films.

According to a first embodiment, the invention concerns a compound of the formula (I): 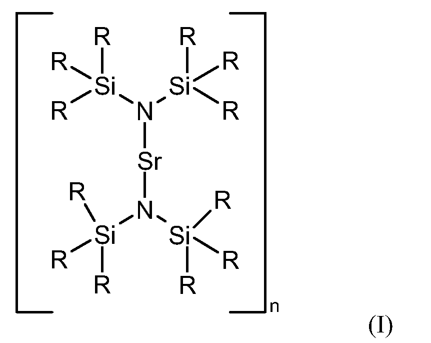 wherein R represents a radical chosen from methyl or ethyl, and n is an integer equal to 1, 2 or 3.

According to a first more particular embodiment R is methyl.

According to a second more particular embodiment, n is equal to 1.

According to a second embodiment, the invention concerns an adduct of a compound of the formula (I) as defined hereinbefore, with a Lewis base.

According to a third more particular embodiment, the invention concerns an adduct of a compound of the formula (I) as defined hereinbefore, wherein the Lewis base is chosen from dimethoxyethane (DME), tetrahydrofuran (THF), diglyme, triglyme, tetragyme or Et₂O.

The invention also relates to a process for the preparation of a compound of the formula (I) as defined hereinbefore, which comprises the reaction of a compound of the formula (II): 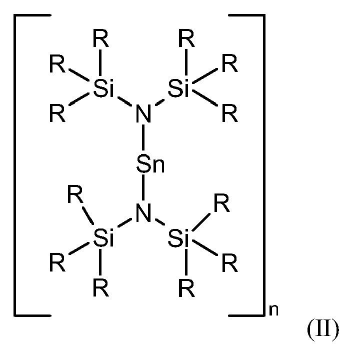 wherein R and n are as defined hereinbefore, with strontium, to produce the compound of the formula (I).

The compound of the formula (II) is a known compound, which is sold by Sigma Aldrich.

According to a further embodiment, the invention concerns the use of a compound of the formula (I) as defined hereinbefore, or of an adduct of said compound of the formula (I), as a strontium thin films precursor in a process for the deposition of a strontium containing film on a substrate, and more particularly in a chemical vapour phase deposition process or in an atomic layer deposition process on a substrate.

The substrate is for instance and without limitation, chosen among the group consisting of Si, SiO2, or a material comprising Ru, Ti, Ta, Mo, W, Hf, Zn, Ir, Pt, Os, or a buffer layer comprising Ba or Sr.

According to another embodiment, the invention concerns a method of deposition of strontium containing thin films on a substrate comprising the following successive steps:
- A step a) of vaporizing the compound of the formula (I) or of the adduct of the compound of the formula (I), as defined hereinbefore;
- A step b) of transporting the vaporized phase prepared at step a), to the reaction chamber;
- A step c) of introducing the vaporized phase transported at step b), in a reaction chamber, in order to provoke the contact of said vaporized phase with a substrate to generate the deposition of a Strontium containing thin film on said substrate.

According to a more particular embodiment of the process as hereinbefore defined, the compound of the formula (I) or the adduct of the compound of the formula (I), is replaced by a mixture of the compound of the formula (I) or of the adduct of the compound of the formula (I) with another metal-organic precursor or other metal-organic precursors, such as a barium organic precursor, a titanium organic precursor, a ruthenium organic precursor or a mixture thereof, to obtain a strontium containing oxide such as, BaSrTiO₃, SrTiO₃, SrRuO₃ or SrBi₂Ta₂O₉ (SBT). These different precursors, including the strontium precursor the formula (I), may be also introduced separately, either continuously or sequentially and not in a single mixture.

Alternatively, the vapour phase deposition process comprises:
- A step a) of vaporizing the compound of the formula (I) or of the adduct of the compound of the formula (I), as defined hereinbefore;
- A step b) of transporting the vaporized phase prepared at step a), to the reaction chamber,
- A step c) of sequentially introducing the vaporized phase transported at step b), in a reaction chamber and another vaporized phase of reactive species, preferably containing at least one oxygen atom.

This alternative is more particularly used for Atomic Layer Deposition.

Alternatively, the vapour phase deposition process comprises:
- A step a) of vaporizing the compound of the formula (I) or of the adduct of the compound of the formula (I), as defined hereinbefore;
- A step b) of transporting the vaporized phase prepared at step a), to the reaction chamber,
- A step c) of mixing the vaporized phase transported in step b) with reactant species,
- A step d) of contacting the said vaporized mixture, with a substrate in the reaction chamber, to generate the deposition of a thin film on said substrate.

The following considerations include more specific embodiments of the process and of the alternatives as hereinbefore defined.

The step a) of the process and the alternative of the process as hereinbefore defined, generally comprises the vaporization of the compound of the formula (I) or of the adduct of the compound of the formula (I) by passing a carrier gas in a heated container containing a controlled amount of said compound of the formula (I) or of said adduct of the compound of the formula (I). The carrier gas is generally chosen from N₂, Ar, He or H₂. The precursor container is heated to a temperature high enough to obtain a sufficient vapour pressure of strontium compound in the precursor gaseous mixture. The heating temperature of the strontium compound container is chosen in the 30°C-200°C range. Preferably, the strontium compound container is heated at a temperature between 90°C and 140°C. The carrier gas flow is comprised between 10 sccm (standard cubic centimeter) and 500 sccm. Preferably, the carrier gas flow is comprised between 50 sccm and 200 sccm.

Alternatively in step a), the compound of the formula (I) or the adduct of the compound of the formula (I), is diluted into a solvent and the liquid precursor mixture is distributed to an evaporator by direct liquid injection. According to this embodiment, the solvent is namely chosen from octane, hexane, heptane, monoglyme, benzene, ethylcyclohexane or tetramethylsilane. The strontium compound is diluted in the solvent at a known concentration. This concentration is preferably comprised between 0.01M and 0.5M and is more particularly around 0.05M.

In yet another embodiment of the invention, the strontium compound is mixed with other metal compounds in the solvent mixture. Such metals could include without limitation Ba, Ti, Ru, Pb, Bi, Ta, Hf, Zr, Mg, Y, Sc, La and other lanthanide series elements, Nb, W or Mo.

In another embodiment of the invention, a third or more metal compound is introduced to obtain a ternary or more oxide. The metal compounds concentration is chosen between 0.01M and 0.5M. Preferably, the chosen concentration is 0.05M for each metal compound. A third (or fourth) metal compound can be furthermore added to obtain ternary (or quaternary) oxides.

In yet another embodiment of the invention, the strontium compound is combined with other precursor(s) not in a single mixture but separately. In one embodiment of the invention, the precursor mixture comprising one or more solvents and one or more metal-organic compound precursors including a strontium metal-organic compound of the formula Sr(tmsa)₂, is continuously injected in an evaporator.

In another embodiment, the precursor mixture comprising one or more solvents and one or more metal-organic compound including a strontium metal-organic compound of the formula Sr(tmsa)₂ is injected in an evaporator by pulses. The pulse frequency is chosen between 0.01 Hz and 100 Hz. The pulse frequency is preferably chosen between 0.1 Hz and 10 Hz. The evaporator temperature is chosen between 50°C and 300°C. Preferably, the evaporator temperature is chosen between 130°C and 180°C.

In yet another embodiment of the invention, the strontium compound is combined with other precursor(s) not in a single mixture but separately, either continuously in an evaporator or sequentially as mentioned above.

In one embodiment, the strontium compound containing vapour is mixed to an oxidizing species. The reactive oxidizing species contains oxygen atoms containing gases selected without limitation from the group consisting of O₂, O₃, NO, NO₂, N₂O, H₂O or H₂O₂. Preferably, for ALD, the reactive mixture contains H₂O as oxidizing species, which is particularly suitable for reaction with Sr(tmsa)₂.

In another embodiment of the invention, where reactants are introduced sequentially, a step comprising the introduction of NH₃ is inserted between the Sr species introduction step and the oxidizing species introduction step. This step enhances the tmsa ligand removal.

In one embodiment of the invention, the source reagent metal-organic compounds are introduced simultaneously in the reactor chamber. The vapor phase precursor composition is contacted with a heated substrate. The substrate temperature is comprised between 150°C and 800°C. Preferably the substrate temperature is chosen between 300°C and 500°C. A thin film containing strontium is grown on the substrate. The reaction chamber is maintained at a pressure comprised between 0.01 Torr (1.33 Pa) and 100 Torr (13332 Pa). Preferably the reactor chamber pressure is chosen between 0.1 Torr and 10 Torr. In one embodiment, the reactor chamber walls are heated only at low temperature. The reactor chamber walls are kept at a temperature between 100°C and 300°C. Preferably the reaction chamber walls are heated at a temperature comprised between 150°C and 250°C. In another embodiment, the reactor chamber walls are heated at a temperature superior to 300°C.

According to another embodiment, the invention relates to the use of a compound of the formula (I) or of an adduct of a compounds of the formula (I) as hereinbefore defined, as a strontium thin films precursor, more particularly in the preparation of semiconductors.

### EXAMPLE 1 - Synthesis of Sr(tmsa)₂

A sample of strontium was mixed in toluene with a sample of bis[bis(trimethylsilyl(amido)]tin. The solution was stirred at 20 °C during 7 days. The obtained crystal was purified by crystallization. White crystalline Sr(tmsa)₂ was obtained in a 38% yield. Elemental Analysis (%): C: 35.34; H: 9.13; N: 6.84.

### EXAMPLE 2 - Thermal properties of Sr(tmsa)₂

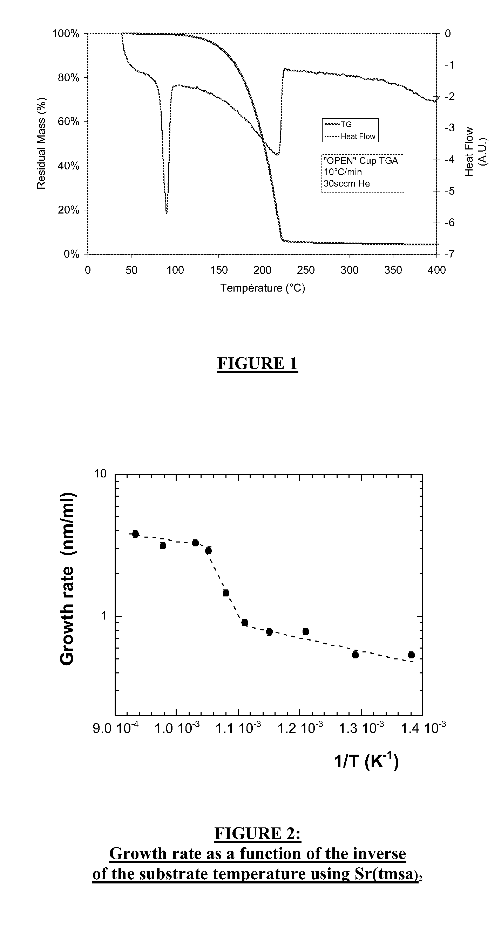

18 mg of bis(trimethylsilylamide)strontium were placed in a crucible. The crucible containing the strontium compound was placed in a thermal gravimetric analyzer. The temperature ramped up at 10 °C/min under a helium flow of 30 sccm and at atmospheric pressure. The strontium compound was fully evaporated at 207 °C. The results are on the graph of Figure 1.

### EXAMPLE 3 - MOCVD using Sr(tmsa)₂

Sr(tmsa)₂ was diluted at 0.05M in octane. The liquid was injected into an evaporator, where it was vaporized by sequential injection. The vaporized reactive species were transported to a reactor chamber using Ar as a carrier gas (400 seem). Oxygen (300 seem) was also introduced in the deposition chamber. Depositions were carried out at a total pressure of 5 Torr (1 Torr = 133,32 Pa), at varying substrate temperatures (400 - 800°C). The decomposition of the Sr(tmsa)₂ precursor was studied in this way, and the corresponding growth rate, shown on Figure 2, was determined for each temperature.

### EXAMPLE 4 - MOCVD of Ba₁₋ₓSrₓTiO₃ thin film using Sr(tmsa)₂ by direct liquid injection

In separated containers, Sr(tmsa)₂, Ba(thd)₂ and Ti(OiPr)₂(thd)₂ were diluted at 0.05M in octane. The liquid reactant mixtures were distributed to an evaporator where they were vaporized by sequential injection. The vaporized reactive mixtures were transported to a reactor chamber through a shower head, where they were mixed to oxidizing species, O₂, at 500°C and 10 Torr. A film of Ba₁₋ₓSrₓTiO₃ was obtained. In another experiment, Ba(tmsa)₂ was used as barium precursor. Alternatively, Sr(tmsa)₂ and the other precursors could be mixed directly in the reactor chamber.

### EXAMPLE 5 - MOCVD of Ba₁₋ₓSrₓTiO₃ thin film using Sr(tmsa)₂ in bubbler

Sr(tmsa)₂ was stored in a container, which was heated at 110°C. A N₂ carrier gas was flowed through the container and carriers Sr(tmsa)₂ vapours to a distribution system to the reactor chamber. Just prior to the reaction chamber, Sr(tmsa)₂ containing vapours were mixed to Ti and Ba compounds containing vapours. The resultant reactive mixture was introduced into a reactor chamber where it was contacted to a substrate. The temperature and the pressure in the reactor chamber were 500°C and 10 Torr respectively.

### EXAMPLE 6 - ALD of Ba₁₋ₓSrₓTiO₃ using Sr(tmsa)₂ in bubbler

Sr(tmsa)₂ was stored in a container, which was heated at 110°C. A N₂ carrier gas was flowed through the container and carriers Sr(tmsa)₂ vapours to a distribution system to the reactor chamber. Ba and Ti precursors containing vapours were similarly distributed to a reaction chamber. Sr(tmsa)₂, Ba and Ti compound were sequentially injected, into the reactor chamber. Between each injection of either Sr, Ba or Ti vapour containing compound, a purge was performed and an oxidizing species such as O₃ was introduced into the reactor chamber, followed by a second purge. The sequence was repeated several numbers of cycles to obtained a desired Ba₁₋ₓSrₓTiO₃ film with a proper stoechiometry.

### EXAMPLE 7 - ALD of SrTiO₃ using Sr(tmsa)₂ in bubbler

Sr(tmsa)₂ was stored in a container, which is heated at 110°C. A N₂ carrier gas was flowed through the container and carriers Sr(tmsa)₂ vapours to a distribution system to the reactor chamber. Ti precursor containing vapours were similarly distributed to a reaction chamber. Sr(tmsa)₂ and Ti compounds were sequentially injected, into the reactor chamber. Between each injection of either Sr or Ti vapour containing compound, a purge was performed and an oxidizing species such as H₂O was introduced into the reactor chamber, followed by a second purge. The sequence was repeated several numbers of cycles to obtained a desired SrTiO₃ film with the proper stoechiometry.

### EXAMPLE 8 - ALD of SrRuO₃ using Sr(tmsa)₂ in bubbler

Sr(tmsa)₂ was stored in a container, which was heated at 110°C. A N₂ carrier gas was flowed through the container and carriers Sr(tmsa)₂ vapours to a distribution system to the reactor chamber. Ru precursor containing vapours were similarly distributed to a reaction chamber. Sr(tmsa)₂ and Ru compounds were sequentially injected, into the reactor chamber. Between each injection of either Sr or Ru vapour containing compound, a purge was performed and an oxidizing species such as O₃ was introduced into the reactor chamber, followed by a second purge. The sequence was repeated several numbers of cycles to obtained a desired SrRuO₃ film with a proper stoechiometry.

The new strontium precursor, bis[bis(trimethylsilyl)amido] Strontium, displays outstanding physical properties including low melting point and high volatility. The deposition of strontium containing oxides can be obtained at lower temperature than in the prior art with conventional and improved strontium metal-organic compounds.

The authors disclose a new strontium precursor with improved physical properties and the methods of deposition of strontium containing thin films using the new strontium precursor.

According to the present invention, the authors disclose the use of Sr(tmsa)₂ (possibly with adducts), as a new strontium thin films precursor that displays outstanding volatility which makes it use for vapour phase deposition processes particularly attractive. Furthermore, bis[bis(trimethylsilyl)amido]strontium has a melting point of 90°C, which makes it distribution in vapour phase particularly suitable.

**Table.1: Thermal Properties of Strontium Precursors**

| Sr precursor | Thermal gravimetric data of strontium precursors: | |
|---|---|---|
| | Temperature of full vaporization (TGA) | Melting point |
| Sr(thd)₂ | 330°C | 210°C |
| Sr(methd)₂ | 400°C | < RT |
| Sr(Me₅Cp)₂ | 320°C | 217°C |
| Sr(iPr₃Cp)₂ | 370°C | N.A. |
| Sr(tmsa)₂ | 207°C | 90°C |

## Claims

1. Compound of the formula (I): 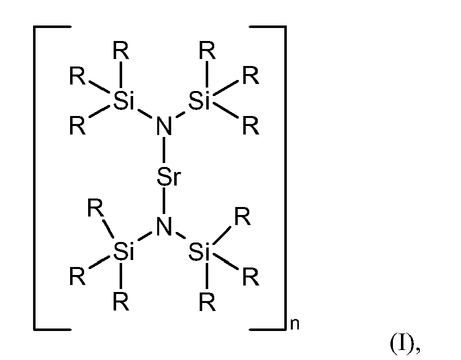 wherein R represents a radical chosen from methyl or ethyl, and n is an integer equal to 1, 2 or 3.

2. Compound of the formula (I) as defined in Claim 1, wherein R is methyl.

3. Compound of the formula (I) as defined in Claim 1 or 2, wherein n is equal to 1.

4. Adduct of a compound of the formula (I) as defined in one of Claim 1 to 3, with a Lewis base.

5. Adduct of a compound of the formula (I) as defined in claim 5, wherein the Lewis base is chosen from dimethoxyethane (DME), tetrahydrofuran (THF), diglyme, triglyme, tetragyme or Et₂O.

6. Process of the preparation of a compound of the formula (I) as defined in one of claim 1 to 3, which comprises the reaction of a compound of the formula (II): 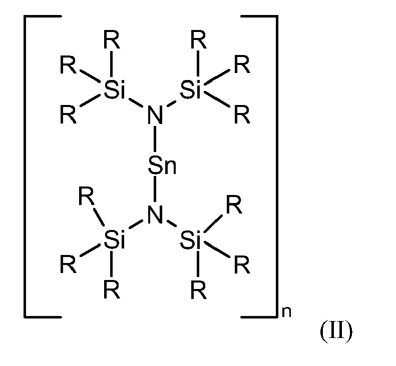 wherein R is as here above defined in said formula (I), with Strontium.

7. Use of a compound of the formula (I) as defined in one of Claim 1 to 3, or of an adduct of said compound of the formula (I) as defined in one of Claim 4 or 5, as a strontium thin films precursor in a process for the deposition of a Strontium containing film on a substrate, and more particularly in a chemical vapour phase deposition process or in an atomic layer deposition process on a substrate.

8. Method of deposition of strontium containing thin films on a substrate comprising the following successive steps:
- A step a) of vaporizing a compound of the formula (I) as defined in one of Claim 1 to 3, or of an adduct of said compound of the formula (I) as defined in one of Claim 4 or 5,
- A step b) of transporting the vaporized phase prepared at step a), to the reaction chamber;
- A step c) of introducing the vaporized phase transported at step b), in a reaction chamber, in order to provoke the contact of said vaporized phase with a substrate to generate the deposition of a Strontium containing thin film on said substrate.

9. Method of deposition of strontium containing thin films on a substrate comprising the following successive steps:
- A step a) of vaporizing a compound of the formula (I) as defined in one of Claim 1 to 3, or of an adduct of said compound of the formula (I) as defined in one of Claim 4 or 5,
- A step b) of transporting the vaporized phase prepared at step a), to the reaction chamber,
- A step c) of sequentially introducing the vaporized phase transported at step b), in a reaction chamber and another vaporized phase of reactive species, preferably containing at least one oxygen atom.

10. Method of deposition of strontium containing thin films on a substrate comprising the following successive steps:
- A step a) of vaporizing a compound of the formula (I) as defined in one of Claim 1 to 3, or of an adduct of said compound of the formula (I) as defined in one of Claim 4 or 5,
- A step b) of transporting the vaporized phase prepared at step a), to the reaction chamber,
- A step c) of mixing the vaporized phase transported in step b) with reactant species,
- A step d) of contacting the said vaporized mixture with a substrate in the reaction chamber, to generate the deposition of a thin film on said substrate.
